Europäisches Patentamt

European Patent Office

Office européen des brevets

(11) Veröffentlichungsnummer: **0 002 797**
**A1**

(12) **EUROPÄISCHE PATENTANMELDUNG**

(21) Anmeldenummer: **78101787.6**

(22) Anmeldetag: **20.12.78**

(51) Int. Cl.²: **H 01 L 21/82, H 01 L 21/265, H 01 L 27/06**

(30) Priorität: **30.12.77 US 865813**

(43) Veröffentlichungstag der Anmeldung: **11.07.79**
**Patentblatt 79/14**

(84) Benannte Vertragsstaaten: **DE FR GB**

(71) Anmelder: **International Business Machines Corporation, Armonk, N.Y. 10504 (US)**

(72) Erfinder: **Antipov, Igor, Lucie Place, Pleasant Valley NY 12569 (US)**

(74) Vertreter: **Mönig, Anton, Dipl.-Ing., Schönaicher Strasse 220, D-7030 Böblingen (DE)**

(54) **Verfahren zur Herstellung einer Halbleiteranordnung mit aktiven Bauelementen und Widerstandsgebieten.**

(57) Bei einem Verfahren zur Herstellung einer Halbleiteranordnung, die neben aktiven Bauelementen Widerstandsgebiete enthält, erfolgt die Bildung der Widerstandsgebiete mittels Ionenimplantation nach der Belegung der Halbleiterschicht mit einer Diffusionsquellschicht für erste Dotierungsgebiete der aktiven Bauelemente, z. B. nach der Basisbelegung, aber vor dem zugehörigen Hochtemperaturschritt, z. B. Basis-Eintreibschritt. Die Temperung der ionenimplantierten Widerstandsgebiete erfolgt dann unter Ausnutzung der für die Bildung weiterer Dotierungsgebiete der aktiven Bauelemente, z. B. Emittergebiete, angewendeten Hochtemperaturbehandlung.

EP 0 002 797 A1

- 1 -

Verfahren zur Herstellung einer Halbleiteranordnung mit
aktiven Bauelementen und Widerstandsgebieten

Die Erfindung befaßt sich mit einem Verfahren zur Herstellung
von integrierten Halbleiterschaltungen unter Verwendung von
Diffusions- wie auch Ionenimplantationsverfahren, wobei auf
dem gleichen Halbleiterchip neben aktiven Bauelementen, z. B.
Transistorstrukturen mit diffundierten Basisgebieten, ionenimplantierte Widerstandsgebiete vorgesehen sind.

Unter Einsatz von Ionenimplantationsverfahren vor sich
gehende Herstellungsverfahren für Halbleiterschaltungen
haben seit einiger Zeit zunehmend erhöhte Beachtung als
Ersatz für Standard-Diffusionsprozesse erlangt. Gegenüber
Diffusionsverfahren liegt ein hautpsächlicher Vorteil der
Ionenimplantation in der damit möglichen besseren Dimensionskontrolle für die in einem Halbleitermaterial zu bildenden aktiven Bereiche wie auch für die jeweiligen Dotierungskonzentrationen. Die heutige Situation auf diesem Gebiet
läßt sich dahingehend zusammenfassen, daß neben der weiterhin
für viele Verfahrensabschnitte in Frage kommenden Diffusionstechnik zunehmend auch Ionenimplantationsschritte für
anspruchsvollere Bauelementvorgaben eingesetzt werden.

Insbesondere für Widerstandgebiete mit hohen Widerstandswerten hat sich eine Überlegenheit der Ionenimplantationstechnik gegenüber der Diffusion gezeigt. Derartige Wider-

FI 977 037

standsgebiete mit hohen Widerstandswerten erfordern geringe Dotierungskonzentrationen, die mittels Diffusion wegen der damit verbundenen Toleranzschwankungen nur einigermaßen schwierig einzustellen sind.

Der Einsatz einer Ionenimplantation zur Ausbildung der entsprechenden Dotierungsgebiete in einem Halbleitersubstrat erfordert jedoch eine Wärmebehandlung, die allgemein unter der Bezeichnung Temperung als zusätzliches Erfordernis bekannt ist. Beispielsweise wird der Herstellungsschritt zur Ausbildung von Emittergebieten einer Transistorstruktur mittels einer Ionenimplantation am vorteilhaftesten so ausgeführt, daß sich an den Implantationsschritt ein Temperungsschritt über etwa 1 Stunde bei mindestens 1000 $^{\circ}$C anschließt, um die in das Emittergebiet eingebrachten Dotierungsatome in ihre endgültige Position gelangen zu lassen und elektrisch zu aktivieren. Ein solcher Wärmebehandlungsschritt könnte für daneben bestehende Widerstandsgebiete Probleme aufwerfen, wenn diese vor oder gleichzeitig mit der Ausbildung der Emittergebiete hergestellt werden. In der industriellen Halbleitertechnik ist man deshalb allgemein dazu übergegangen, etwaige neben den aktiven Bauelementen vorzusehende Widerstandsgebiete nach der Ausbildung der übrigen Gebiete, die einen thermischen Behandlungsschritt erfordern, herzustellen. Wegen der größeren Anzahl von Maskierungsschritten ist darin aber im allgemeinen ein erhöhter Prozeßaufwand zu sehen, den man vermeiden möchte. Da bei ionenimplantierten Widerstandsgebieten die maximale Konzentration im übrigen nicht an der Oberfläche auftritt, ergeben sich darüber hinaus nicht selten Probleme hinsichtlich der Stabilität solcher Widerstände.

Aus der US-Patentschrift 3 933 528 ist auch bereits ein Verfahren bekannt, bei dem Basis- und Widerstandsgebiete gleichzeitig durch einen Implantationsschritt hergestellt werden, wobei ein mit der abschließenden Bildung der Emitter-

- 3 -

gebiete zusammenhängender Wärmebehandlungsschritt als Temperungsschritt der vorher implantierten Widerstandsgebiete dient. Wünschenswert wäre in manchen Fällen demgegenüber, die Herstellung der Basisgebiete mittels Diffusionsverfahren beibehalten zu können.

Die Erfindung, wie sie in den Patentansprüchen gekennzeichnet ist, löst die Aufgabe, für derartige Halbleiteranordnungen mit sowohl aktiven Bauelementen als auch passiven Widerstandsgebieten ein in dem Sinne verbessertes Herstellungsverfahren bereitzustellen, das ohne einen wesentlich erhöhten Prozeßaufwand die separate Definition der Leitfähigkeit der Widerstandsgebiete unter Vermeidung der oben genannten Nachteile ermöglicht. Die durch die Erfindung erreichten Vorteile sind im wesentlichen darin zu sehen, daß damit für einen Teil eines insgesamten Herstellungsverfahrens eine Verfahrensabfolge angegeben ist, die es gestattet, den Ionenimplantationsschritt direkt und ausschließlich zugeschnitten auf die Bedürfnisse der jeweils angestrebten Eigenschaften der Widerstandsgebiete prozeßkompatibel mit ansonsten vorgesehenen Diffusionsverfahren einsetzen zu können.

Die Erfindung wird im folgenden anhand eines Ausführungsbeispiels unter Zuhilfenahme der Zeichnungen näher erläutert.

Es zeigen:

Fign. 1A bis 1F    in jeweiligen Querschnittsdarstellungen verschiedene Herstellungsphasen zur Erläuterung der Erfindung und

Fign. 2 und 3    Konzentrationsprofile für die nach der Erfindung ausgeführten Basis- und Widerstandsgebiete.

FI 977 037

- 4 -

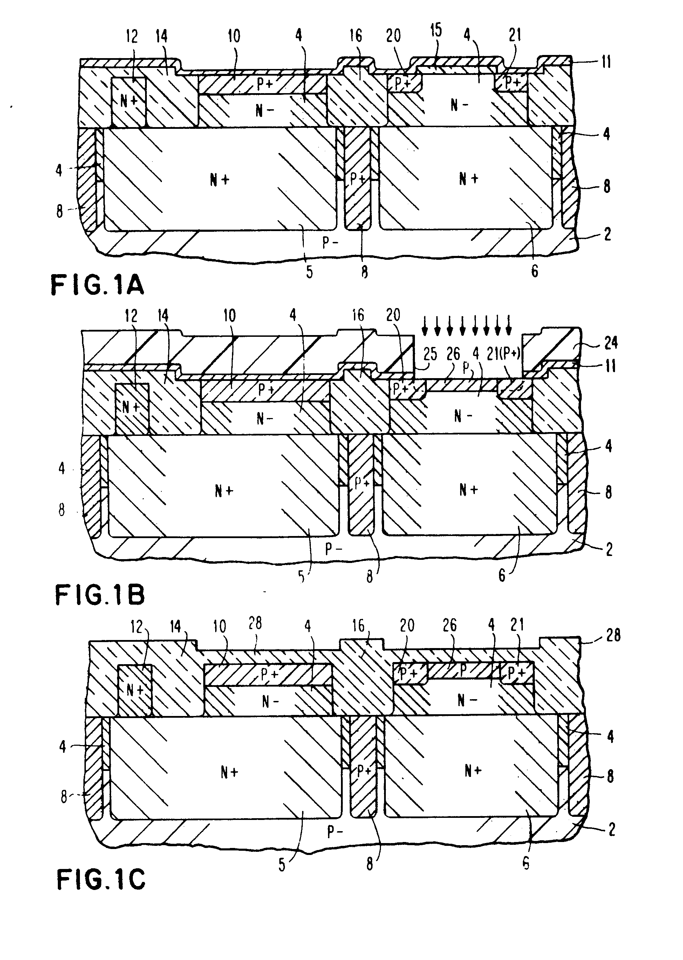

Fig. 1A illustriert in einer Querschnittsdarstellung einen Ausschnitt aus einer teilweise bereits fertiggestellten integrierten Schaltungsanordnung, enthaltend eine $N^-$-leitende Epitaxieschicht 4, die auf einem $P^-$-Substrat 2 aufgebracht ist. Mit 5 und 6 sind die Subkollektorbereiche und mit 8 die Isolationsbereiche bezeichnet, die sich in die Epitaxieschicht durch Ausdiffusion ausgebreitet haben. Der Bereich 6 soll dabei die Funktion des Isolierbereichs für den noch zu bildenden P-leitenden Widerstand bilden. Die Epitaxieschicht 4 weist vorzugsweise eine Dicke von etwa 2 µm oder weniger sowie eine Konzentration von etwa 2,1 bis 2,3 x $10^{16}$ Atome/$cm^3$ auf.

Das Basisgebiet 4 wird zunächst in der Epitaxieschicht 4 durch eine Belegung mit $BBr_3$ gebildet. In typischen Fällen erfolgt diese Belegung in einer trockenen Atmosphäre aus Sauerstoff und Argon über etwa 1 Stunde, um so eine etwa 40 nm dicke Borsilikatglasschicht(BSG) 11 zu bilden.

Weiterhin wurde bereits ein auf den Subkollektor hinunterreichendes Anschlußgebiet 12 erstellt. Dieses Anschlußgebiet 12 ist vom $P^+$-Basisgebiet 10 durch ein Oxidisolationsgebiet 14 getrennt. Auf der gegenüberliegenden Seite ist das Basisgebiet 10 über das Oxidisolationsgebiet 16 von dem für den zu bildenden Widerstand vorgesehenen Halbleitergebiet getrennt. Im vorliegenden Ausführungsbeispiel ist ein Widerstand vom P-Leitungstyp angenommen, worauf die Erfindung jedoch nicht beschränkt zu sein braucht. In gleicher Weise können beispielsweise unter Verwendung von Arsen oder Phosphor auch N-leitende Widerstandsgebiete hergestellt werden. In einem solchen Fall würde das Gebiet unterhalb des N-leitenden Transistors P-leitend und vorzugsweise gleichzeitig mit den Isolationsgebieten 8 hergestellt sein. Die genannte mögliche Umkehrung der Leitungstypen gilt selbstverständlich im Rahmen dieser Erfindung auch für die übrigen Halbleitergebiete. Hinzuweisen ist ferner darauf, daß nicht alle im

FI 977 037

vorliegenden Ausführungsbeispiel vorgesehenen Halbleiter- gebiete überhaupt oder in der gezeigten Form vorgesehen werden müssen, beispielsweise kann anstelle einer Oxidisolation auch eine Isolation mittels gesperrter Halbleiterübergänge benutzt werden.

In Fig. 1A sind mit 20 und 21 die Anschluß- bzw. Kontaktgebiete für den P-leitenden Widerstand bezeichnet. Diese Gebiete werden mit den gleichen Verfahrensschritten wie für das $P^+$-Gebiet hergestellt.

Fig. 1B illustriert den Zustand, bei dem eine Photolackschicht 24 auf die Oberfläche aufgebracht, belichtet und entwickelt worden ist, so daß darin das Fenster 25 für die Bildung des P-leitenden Widerstandsgebietes 26 geöffnet ist. Im Bereich dieses Fensters werden dann die Oxidschicht 15 sowie die BSG-Schicht 11 durch einen Ätzschritt entfernt, während die als Maske dienende Photolackschicht 24 die übrige Halbleiterfläche bedeckt. In dem hier behandelten bevorzugten Ausführungsbeispiel wird für die nachfolgende Implantation Bor mit einer Energie von 70 keV und einer Dosis von ungefähr $2,2 \times 10^{13}$ Ionen/cm$^2$ verwendet. Damit ergibt sich nach Abschluß des gesamten Herstellungsverfahrens ein Widerstands- wert von ungefähr 2000 $\Omega/\square$. Statt der gezeigten Implantation direkt in die Epitaxieschicht 4 kann auch eine Implantation durch ein Schutzoxid von ungefähr 30 nm Dicke praktiziert werden.

Die in diesem Verfahrensschritt gewählte Dosis entspricht der für den Widerstand mit dem höchsten Wert erforderlichen Dosis. Die Verfahrensschritte der Ausbildung einer Photolackmaske, des Belichtens selektiver Bereiche und der anschließenden Ionenimplantation können für verschiedene Widerstandsgebiete ggf. wiederholt werden, wenn weitere Widerstände mit geringeren Werten gebildet werden sollen. In dieser Verfah-

- 6 -

rensstufe können überdies zusätzlich oder anstelle der P-Widerstandsgebiete auch N-Widerstandsgebiete gebildet werden.

Im Anschluß an die Implantation des Widerstandsgebiets 26 werden die Photolackschicht 24 und die BSG-Schicht 11 durch Abziehen entfernt. In einem gleichzeitig den Eintreibschritt für die Basis darstellenden Oxidationsvorgang bildet sich auf der Halbleiteroberfläche eine relativ dicke Oxidschicht 28. Dieser kombinierte Eintreib- und Reoxidationsschritt erfolgt vorzugsweise in einer Atmosphäre von trockenem Sauerstoff und Wasserdampf bei 925 $^\circ$C für etwa 1 1/2 Stunden bis zu einer Dicke von etwa 80 nm. Andere Schichtdicken sind jedoch ebenfalls zulässig. Infolge dieses Eintreib-(drive-in) Schrittes nimmt die Eindringtiefe der Gebiete 10, 20 und 21 etwas zu.

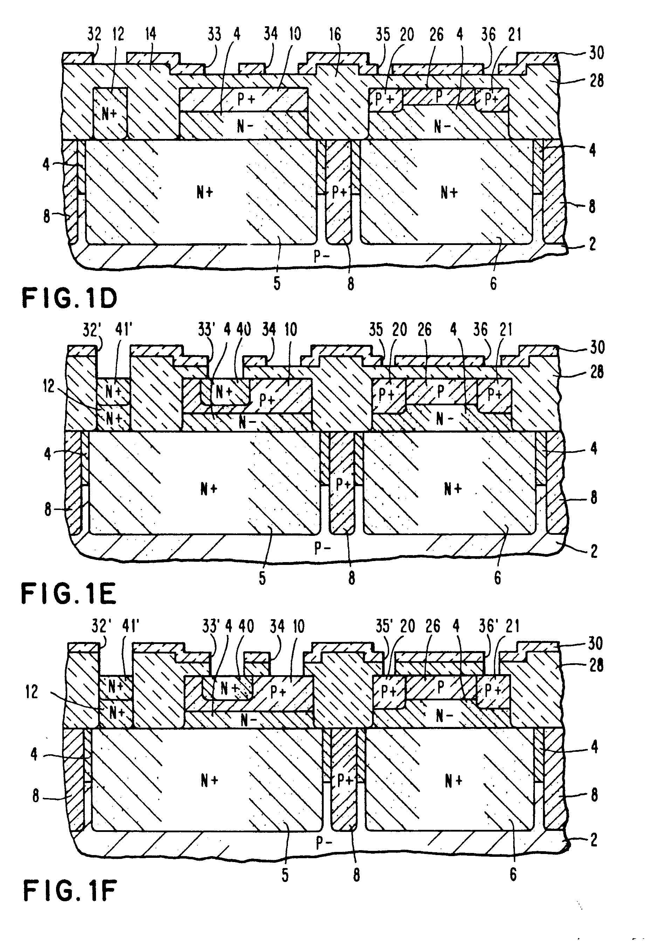

Anschließend wird in konventioneller Weise durch chemischen Niederschlag aus der Dampfphase eine Siliciumnitridschicht 30 aufgebracht. Dazu wird beispielsweise eine Zusammensetzung aus Silan, Stickstoff und Ammoniak bei einer Temperatur von etwa 1000 $^\circ$C verwendet und eine Schichtdicke von 160 nm oder weniger gebildet. Mittels konventioneller Lithographie- und (Naß- oder Trocken-)Ätztechniken werden in der Nitridschicht 30 die in Fig. 1D gezeigten Öffnungen 32 bis 36 hergestellt. Die zugehörige Photolackmaske ist nicht gezeigt. Im Falle einer Naßätzung kann über der Siliciumnitridschicht eine Siliciumdioxidschicht zum Schutz gegen ein Ätzen des Photolacks vorgesehen werden. Die Nitridschicht 30 bildet dabei eine alle späteren Kontakte und Gebiete in Form entsprechender Maskenöffnungen definierende Maskenschicht.

Wie aus Fig. 1E hervorgeht, werden nun in der Oxidschicht 28 Öffnungen 32' und 33' hergestellt, indem die übrigen Oberflächenbereiche durch eine (nicht dargestellte) Photolackmaske abgedeckt werden. Dieser Schritt dient dazu, den Halb-

FI 977 037

- 7 -

leiterkörper über den Anschlußgebieten 12 für den Subkollektor und den Bereich des Basisgebiets 10 freizulegen, in dem das Emittergebiet für den Transistor vorgesehen werden soll. Anschließend wird das Emittergebiet 40 innerhalb des Basisgebietes 10 durch eine Arsen-Diffusion, vorzugsweise durch eine Kapseldiffusion der in der US-Patentschrift 4 049 478 der Anmelderin behandelten Art, eingebracht. Gleichzeitig wird der Dotierungsgrad des Subkollektor-Anschlußgebiets 12 durch das Einbringen derselben Dotierungsstoffe angehoben, so daß sich ein Gebiet 41' hoher Leitfähigkeit bildet. Die Diffusion für das Emittergebiet 40 erfolgt in einem standardmäßigen Diffusionsofen, der über etwa 145 Minuten auf einer Temperatur von etwa 1000 $^{\circ}$C gehalten wird. Alternativ könnte der Emitter auch mittels Ionenimplantation und anschließendem Temperschritt bei etwa derselben Temperatur für etwa 100 Minuten gebildet werden. Der für die Diffusion oder den Temperschritt des Emittergebiets ohnehin erforderliche Verfahrensschritt stellt dabei für das Widerstandsgebiet 26 den zugehörigen Temperschritt dar.

Der grundsätzliche Verfahrensgang wird abgeschlossen, indem die Gebiete 40 und 41' mit einer (nicht gezeigten) Photolackmaske abgedeckt und die Oxidschicht von den mit 34 bis 36 bezeichneten Öffnungsbereichen zur Bildung der dann mit 34', 35' und 36' bezeichneten Öffnungen entfernt wird. Die Photolackschicht wird dann wiederum durch Abziehen entfernt, so daß alle mit einer Metallisierung zu versehenden Gebiete freigelegt sind, vgl. Fig. 1F. Die anschließend vorzunehmende (nicht mehr in den Figuren gezeigte) Metallisierung erfolgt mittels konventioneller Aufdampf- oder Kathodenzerstäubungsverfahren. Für die Metallisierung läßt sich Platin und Kupfer-Aluminium oder Platin, Chrom und Kupfer-Aluminium etc. verwenden. Dieser Verfahrensschritt ist jedoch nicht mehr Gegenstand vorliegender Erfindung und braucht deshalb nicht mehr gesondert behandelt zu werden.

FI 977 037

- 8 -

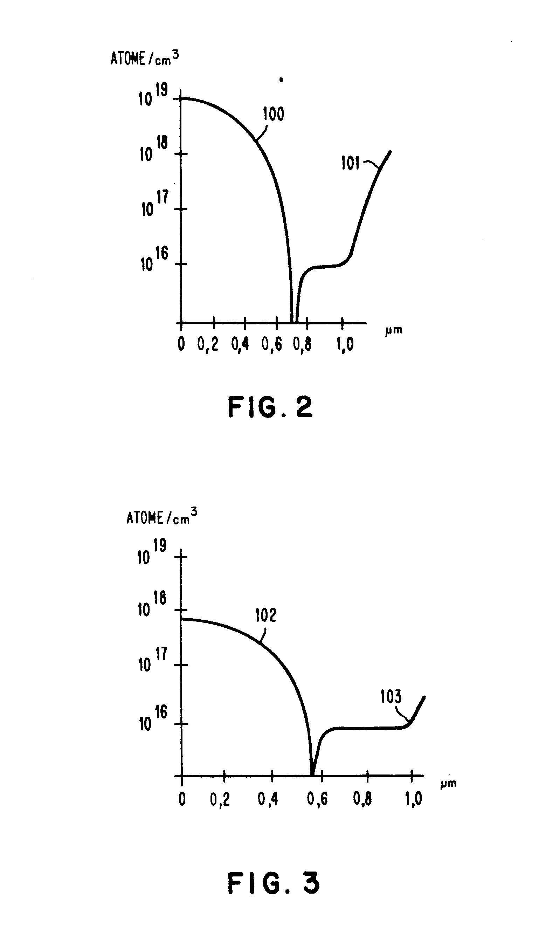

In den Fign. 2 und 3 sind die durch den oben beschriebenen Prozeßablauf in der Epitaxieschicht 4 für das Basisgebiet 10 bzw. das Implantationsgebiet 26 erzielten (Netto-)Konzentrationsprofile illustriert. Die Anschlußgebiete 20 und 21 für den Widerstand weisen dabei dasselbe Profil wie das Basisgebiet auf, da sie mit den gleichen Prozeßschritten erzeugt worden sind. Die mit 100 bzw. 102 bezeichneten Kurven geben das Profil des P-leitenden Basisgebiets 10 bzw. des Widerstandsgebiets 26 wieder. Die mit 101 bzw. 103 bezeichneten Kurven entsprechen dem Profil für die $N^+$-leitenden Subkollektorbereiche 5 bzw. 6.

Hervorzuheben bei diesen Darstellung ist die sich insgesamt ergebende Ähnlichkeit der jeweiligen Profile. Das Profil für das Widerstandsgebiet weist dabei sehr große Ähnlichkeit mit dem des Basisgebiets auf, woraus sich eine hohe Zuverlässigkeit für den so gebildeten Widerstand herleiten läßt. Die für das Widerstandsgebiet 26 festzustellende höchste Konzentration liegt an der Oberfläche. Daher liegt eine hohe Unempfindlichkeit gegen die Gefahr einer Oberflächeninversion vor, wie sie aus darüberliegenden Isolierschichten oder aus Beeinflussungen durch nachfolgende Schritte oder Deckschichten ansonsten zu befürchten wäre.

Soweit schließlich statt P-leitender Widerstandsgebiete N-leitende Widerstandsgebiete in der beschriebenen Weise hergestellt werden sollen, wären die Anschlußgebiete für das Widerstandsgebiet vorteilhaft mit den für die Herstellung des Emittergebietes eingesetzten Verfahrensschritten auszubilden.

0002797

- 1 -

PATENTANSPRÜCHE

1. Verfahren zur Herstellung einer Halbleiteranordnung mit aktiven Bauelementen und Widerstandsgebieten innerhalb einer Halbleiterschicht eines ersten Leitungstyps, gekennzeichnet durch einen folgendermaßen ausgestalteten Verfahrensablauf im Rahmen eines insgesamten Herstellungsverfahrens:

a) In einem Belegungsschritt werden selektiv erste Oberflächenbereiche (10) der Halbleiterschicht (4) mit einer Dotierstoffe des zweiten Leitungstyps enthaltenden Diffusionsquellschicht (11) belegt;

b) in Gegenwart einer die übrigen Halbleiterflächen bedeckenden Schutzschicht (24) wird in zweiten, 'für die Widerstandsgebiete (26) vorgesehenen Oberflächenbereichen der Halbleiterschicht (4) eine Implantation von die Leitfähigkeit des jeweiligen Widerstandsgebietes (26) bestimmenden Dotierstoffionen vorgenommen (Fig. 1B);

c) mittels einer bei hohen Temperaturen in oxidierender Atmosphäre erfolgenden Wärmebehandlung werden die in der Diffusionsquellschicht (11) enthaltenden Dotierstoffe zur Bildung der ersten aktiven Gebiete (10) in die Halbleiterschicht eingetrieben (Fig. 1C);

FI 977 037

d) in Teilgebiete der ersten Oberflächengebiete (10)
für die vorgesehenen aktiven Bauelemente werden
Dotierstoffe vom ersten Leitungstyp zur Bildung
von zweiten Dotierungsgebieten (40) für die aktiven
Bauelemente eingebracht (Fig. 1E);

e) die mit dem Verfahrensschrit d) in Verbindung stehende Wärmebehandlung der Halbleiteranordnung bei
hohen Temperaturen wird als Temperungsschritt für
die im Verfahrensschritt b) mittels Ionenimplantation vorbehandelten Widerstandsgebiete (26) benutzt.

2.  Verfahren nach Anspruch 1,
dadurch gekennzeichnet,
daß die die Leitfähigkeit der Widerstandsgebiete (26)
bestimmenden Dotierstoffionen (Verfahrensschritt b))
vom zweiten Leitungstyp sind und die Herstellung der
Anschlußgebiete (20, 21) für die Widerstandsgebiete (26)
zusammen mit der Ausbildung der ersten aktiven Gebiete
(10) im Verfahrensschritt a) erfolgt.

3.  Verfahren nach Anspruch 1,
dadurch gekennzeichnet,
daß die die Leitfähigkeit der Widerstandsgebiete (26)
bestimmenden Dotierstoffionen (Verfahrensschritt b))
vom ersten Leitungstyp sind und die Herstellung der
Anschlußgebiete (20, 21) für die Widerstandsgebiete (26)
zusammen mit der Ausbildung der zweiten aktiven Gebiete
(40) im Verfahrensschritt d) erfolgt.

4.  Verfahren mindestens nach Anspruch 1,
dadurch gekennzeichnet,
daß bei dem im Verfahrensschritt a) vorgesehenen Belegungsschritt $BBr_3$ in einer Sauerstoff enthaltenden

FI 977 037

Atmosphäre bei einer solchen Temperatur und über eine solche Zeit auf die Halbleiterschicht aufgebracht wird, daß dabei Boratome in die ersten Oberflächenbereiche eindringen können, und daß der $BBr_3$-Niederschlag vor der im Verfahrensschritt c) vorgesehenen Behandlung in oxidierender Atmosphäre wieder entfernt wird.

5. Verfahren nach Anspruch 4,
dadurch gekennzeichnet,
daß der $BBr_3$-Niederschlag auch an den für die Anschlußgebiete (20, 21) eines Widerstandsgebietes (26) vorgesehenen Stellen der Halbleiterschicht (4) vorgenommen wird.

6. Verfahren mindestens nach Anspruch 1,
dadurch gekennzeichnet,
daß mit der Ausbildung der ersten bzw. zweiten Dotierungsgebiete für die aktiven Bauelemente die Basisbzw. Emittergebiete (10, 40) einer Transistorstruktur hergestellt werden.

7. Verfahren mindestens nach Anspruch 1,
dadurch gekennzeichnet,
daß im Anschluß an die im Verfahrensschritt b) vorgenommene Ionenimplantation mittels mindestens einer weiteren Ionenimplantation weitere Widerstandsgebiete mit demgegenüber unterschiedlichem Widerstandswert gebildet werden.

8. Verfahren mindestens nach Anspruch 1,
gekennzeichnet durch
die Anwendung einer Kapseldiffusion für den Verfahrensschritt d).

9. Verfahren mindestens nach Anspruch 1,
   gekennzeichnet durch
   die Anwendung einer Ionenimplantation im Verfahrensschritt d).

FIG.1A

FIG.1B

FIG.1C

FIG.1D

FIG.1E

FIG.1F

0002797

FIG. 2

FIG. 3

Europäisches
Patentamt

**EUROPÄISCHER RECHERCHENBERICHT**

0002797
Nummer der Anmeldung

EP 78 10 1787

| Kategorie | EINSCHLÄGIGE DOKUMENTE Kennzeichnung des Dokuments mit Angabe, soweit erforderlich, der maßgeblichen Teile | betrifft Anspruch | KLASSIFIKATION DER ANMELDUNG (Int.Cl.²) |
|---|---|---|---|
| X | US - A - 4 021 270 (M.R. HUNT et al.) <br><br> * Figuren 1-9; Spalte 2, Zeile 45 - Spalte 6, Zeile 40 * <br><br> --- | 1,2,4-8 | H 01 L 21/82 <br> 21/265 <br> 27/06 |
| A | IBM TECHNICAL DISCLOSURE BULLETIN, Band 18, Februar 1976, New York, USA, C.A. BARILE et al. "Implanted resistor formed after the formation of the emittor in a transistor process", Seiten 2890-2891 <br><br> * Seiten 2890-2891 * <br><br> --- | 1 | |
| A | US - A - 4 025 364 (P.R. SMITH) <br><br> * Figuren 1,2; Ansprüche * <br><br> --- | 1 | RECHERCHIERTE SACHGEBIETE (Int. Cl.²) <br><br> H 01 L 21/82 <br> 21/265 <br> 27/06 |
| P | IBM TECHNICAL DISLCOSURE BULLETIN, Band 21, September 1978, New York, USA, L.H. LEE et al. "Forming semiconductor devices having ion-implanted resistor and diffused regions" Seiten 1441-1442 <br><br> * Seiten 1441-1442 * <br><br> ---- | 1,2,4-8 | |

KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 27-02-1979 | CARDON |

EPA form 1503.1  06.78